# EUROPEAN PATENT SPECIFICATION

(11) **EP 3 468 331 B1**
(45) Date of publication and mention of the grant of the patent: **20.10.2021**
(21) Application number: 16903108.5
(22) Date of filing: 25.05.2016
(51) Int. Cl.: H05K 13/04, B25J 17/00

(54) **NOZZLE HOLDING MECHANISM AND COMPONENT MOUNTING DEVICE**
DÜSENHALTEMECHANISMUS UND KOMPONENTENMONTAGEVORRICHTUNG
MÉCANISME DE MAINTIEN DE BUSE ET DISPOSITIF DE MONTAGE DE COMPOSANTS

(43) Date of publication of application: 10.04.2019
(73) Proprietor: Fuji Corporation, Chiryu-shi, Aichi 472-8686 (JP)
(72) Inventor: IMURA, Jinya, Chiryu Aichi (JP)
(74) Representative: Grünecker Patent- und Rechtsanwälte PartG mbB
(86) International application number: PCT/JP2016/065449
(87) International publication number: WO 2017/203626

(56) References cited:
- JP-A- 2000 091 794
- JP-A- 2000 091 794
- JP-A- 2004 158 658
- JP-A- 2004 158 658
- US-A1- 2006 150 404

## Description

### Technical Field

The present invention relates to a nozzle holding mechanism and a component mounting device.

### Background Art

There are known component mounters that pick up an electronic component supplied from a component supply device using negative pressure at the tip of a nozzle, move the nozzle to a specified position above a board, and mount the electronic component at a specified position on the board by canceling the negative pressure. Among such component mounting devices, there is a known device that uses negative pressure to hold a held surface of a nozzle to a nozzle-holding surface of a head (for example, patent literature 1).

Further related background art is disclosed in patent literature 2.

### Citation List

### Patent Literature

Patent literature 1: JP-A-2006-261325
Patent literature 2: JP 2004 158658 A

### Summary of Invention

### Technical Problem

However, there is a problem in that a nozzle held to a nozzle-holding surface of a head by negative pressure drops from the head if the supply of negative pressure is interrupted for some reason. As a mechanism to prevent a nozzle from dropping, one may consider providing a resin pin on one of the nozzle-holding surface of the head or the held surface of the nozzle, and a hole on the other of the nozzle-holding surface of the head and the held surface of the nozzle into which the pin is inserted. In this case, even if the supply of negative pressure is interrupted, because the nozzle is held to the head by the pin, the nozzle will not drop from the head. However, if using such a mechanism, when performing automatic nozzle exchange, the head will still be held by the pin even when the negative pressure is turned off, so work to remove the pin is required. For example, the required work may be removing the pin by closing the shutter of the nozzle stocker with a nozzle inside a storage hole of the nozzle stocker and then pulling up the head as the nozzle is held by the shutter. Thus, there is a problem that a nozzle cannot be removed quickly during nozzle exchange.

The present invention solves the above problems and an object thereof is to quickly remove a nozzle during nozzle exchange without the nozzle dropping from the head even when a problem causes the negative pressure to be canceled.

### Solution to Problem

A nozzle holding mechanism of the present invention is configured to hold a held surface of a nozzle to a nozzle-holding surface of a head using negative pressure, the nozzle holding mechanism including:
a recess provided on one of the nozzle-holding surface or the held surface;
a pressure adjusting means connected to the recess;
a magnet attached to the head so as to face the recess and to have a changeable positional relationship with the nozzle-holding surface, the magnet being arranged such that at a normal position the magnet is separated from the nozzle-holding surface by an elastic body in a state in which the nozzle is not being held by the nozzle-holding surface, the magnet being configured to provide a magnetic force to hold the nozzle to the head only by means of the magnetic force; and
a metal member attached to the held surface of the nozzle at a position opposite the magnet on the held surface of the nozzle and made from a material attracted to the magnet;
wherein
when negative pressure is supplied via the pressure adjusting means to a pressure adjustment chamber formed from the recess that is connected to the nozzle-holding surface and the held surface, due to the negative pressure the held surface is configured to be sucked to the nozzle-holding surface, and the magnet is configured to be moved against biasing of the elastic body from the normal position to an attract position at which the metal member is configured to be attracted to the magnet by magnetic force, and, when positive pressure is supplied to the pressure adjustment chamber via the pressure adjusting means, due to the biasing by the elastic body and the positive pressure the magnet is configured to be moved to the normal position such that the attraction of the metal member to the held surface is released.

With this nozzle holding mechanism, when negative pressure is supplied to a pressure adjustment chamber formed from the recess that is connected to the nozzle-holding surface and the held surface, due to the negative pressure the held surface of the nozzle is sucked to the nozzle-holding surface. Also, the magnet attached to the head is moved by the negative pressure against the biasing of the negative body from the normal position to the attract position (a position at which the metal member attached to the nozzle is attracted to the magnet by magnetic force). That is, the nozzle is held by being sucked to the head by negative pressure, and is held by being attracted to the head by magnetic force. Therefore, even if the negative pressure is interrupted, the nozzle is held to the head by the magnetic force and does not drop from the head. Also, to remove the nozzle, positive pressure is supplied to the pressure adjustment chamber. When this is done, the nozzle is no longer sucked to the head by negative pressure. Also, because the magnet is moved to the normal position by the positive pressure and the biasing of the elastic body, the attraction to the metal member provided on the nozzle is canceled. That is, the nozzle is no longer attached to the head by the magnetic force. Thus, the nozzle can be removed quickly during nozzle exchange by supplying positive pressure to the pressure adjustment chamber.

Note that, as a "member to which the magnet is attached", for example, a material consisting mainly of an iron group element (iron, cobalt, nickel) may be used.

With a nozzle holding mechanism of the present invention, the configuration may be such that the magnet, when at the attract position, attracts the metal member in a state opposite to and separated by a gap from the metal member. Accordingly, because the magnet does not directly contact the metal member, the occurrence of cracks or the like is unlikely. This means the magnet can be used for a long time. Also, when positive pressure is supplied to the pressure adjustment chamber, because the positive pressure causes the magnet to be raised thereby increasing the gap between the magnet and the metal member, it is easy for the magnet to return to the normal position from the attract position.

A nozzle holding mechanism of the present invention may further include: a cylindrical magnet holder configured to hold the magnet, wherein the magnet is held by the magnet holder such that a height of a lower surface of the magnet is higher than a lower surface of the the magnet holder, and pressure of the pressure adjustment chamber reaches the lower surface of the magnet via an outlet of the magnet holder, such that, when the magnet is at the attract position, the lower surface of the magnet holder contacts the metal member and the lower surface of the magnet attracts the metal member in a state in which the lower surface of the magnet is separated by a gap from the metal member. Thus, when the magnet is at the attract position, because the gap between the magnet and the metal member is maintained by the lower surface of the magnet holder contacting the metal member, it is easy to manage the size of the gap. Also, when positive pressure is supplied to the pressure adjustment chamber, because the positive pressure of the pressure adjustment chamber reaches the lower surface of the magnet via the outlet of the magnet holder, it is easy to push up the magnet positioned at the attract position.

Note that, as an "outlet of the magnet holder", a cutout, slit, or the like provided on the lower surface of the magnet holder, or a through-hole provided near the lower surface of the magnet holder, may be provided.

A component mounting device of the present invention is a device provided with the above nozzle holding mechanism. Thus, the component mounting device achieves the same effects as the above nozzle holding mechanism.

### Brief Description of Drawings

Fig. 1

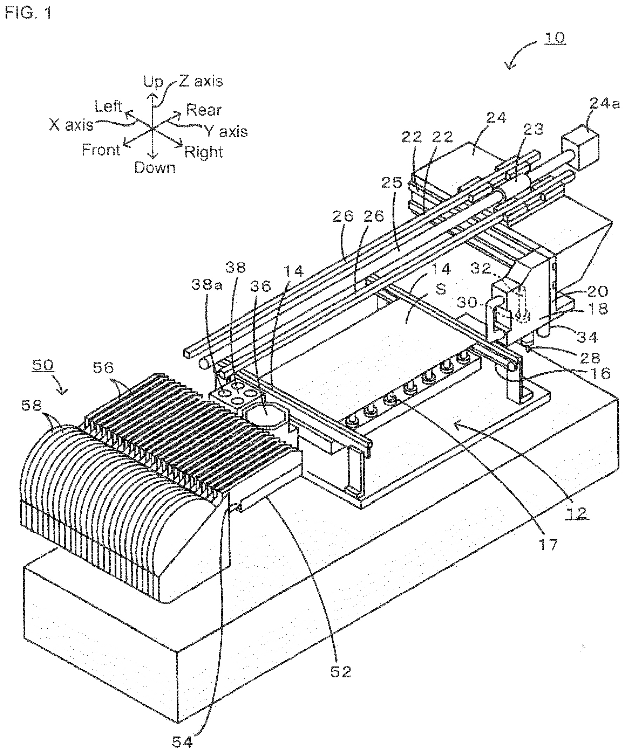

   Fig. 1 is a perspective view of component mounting device 10.
Fig. 2

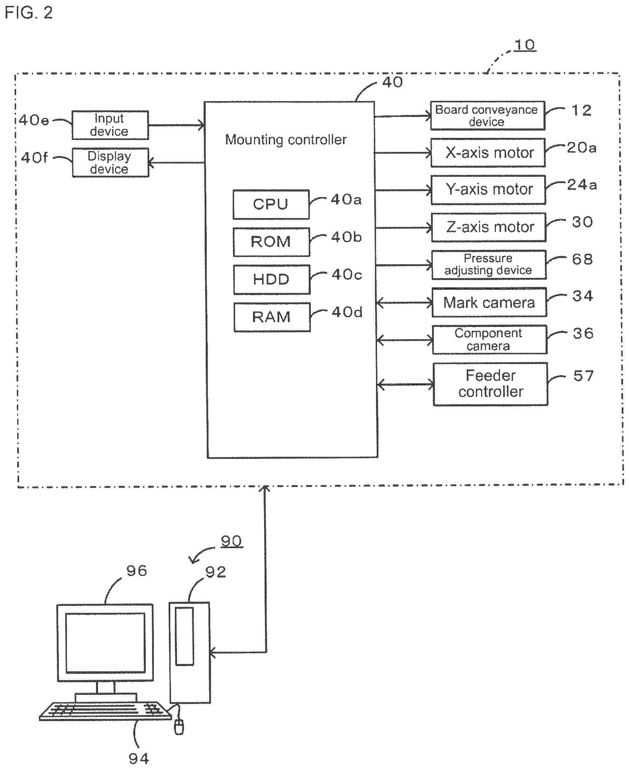

   Fig. 2 shows electrical connections of component mounting device 10.
Fig. 3

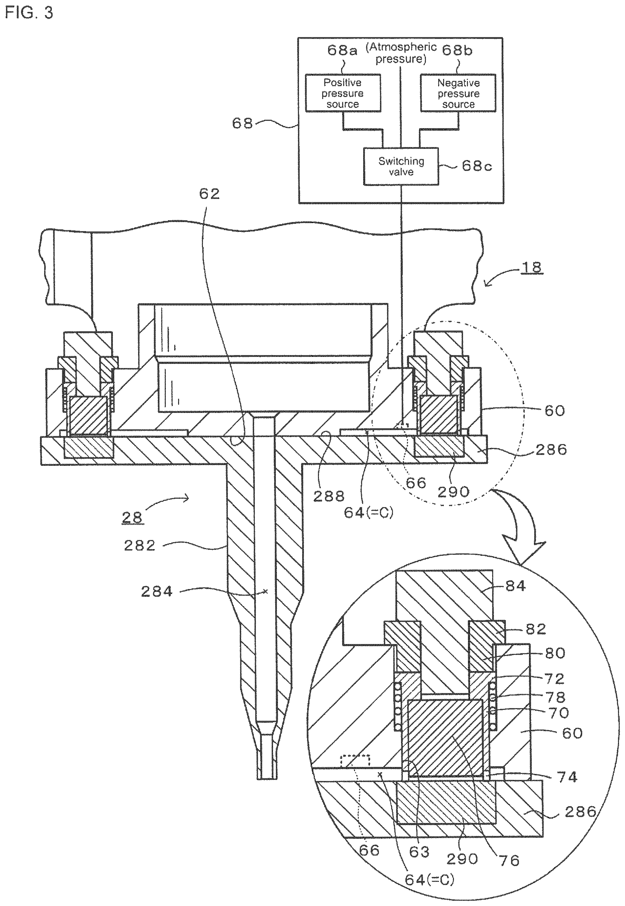

   Fig. 3 shows a cross section of a nozzle holding mechanism whereby head 18 holds nozzle 28.
Fig. 4

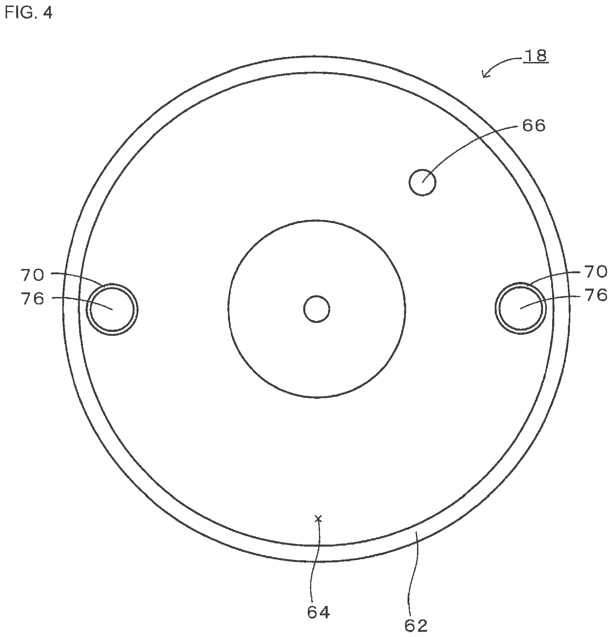

   Fig. 4 shows nozzle-holding surface 62 from below.
Fig. 5

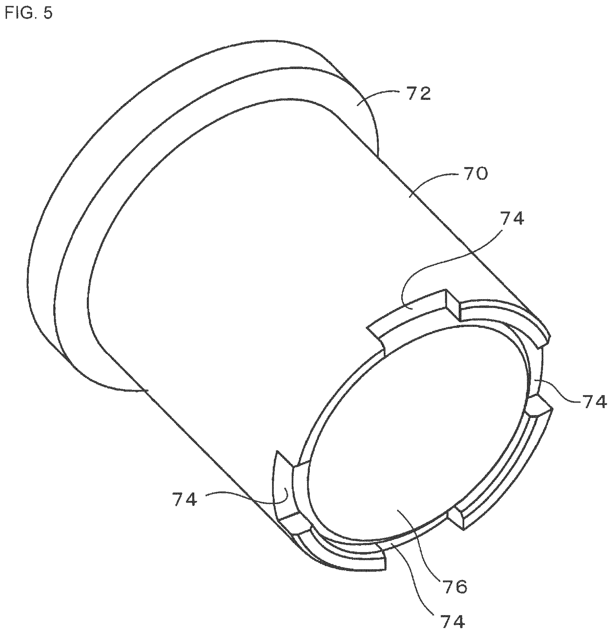

   Fig. 5 shows magnet holder 70 holding magnet 76 diagonally from below.
Fig. 6

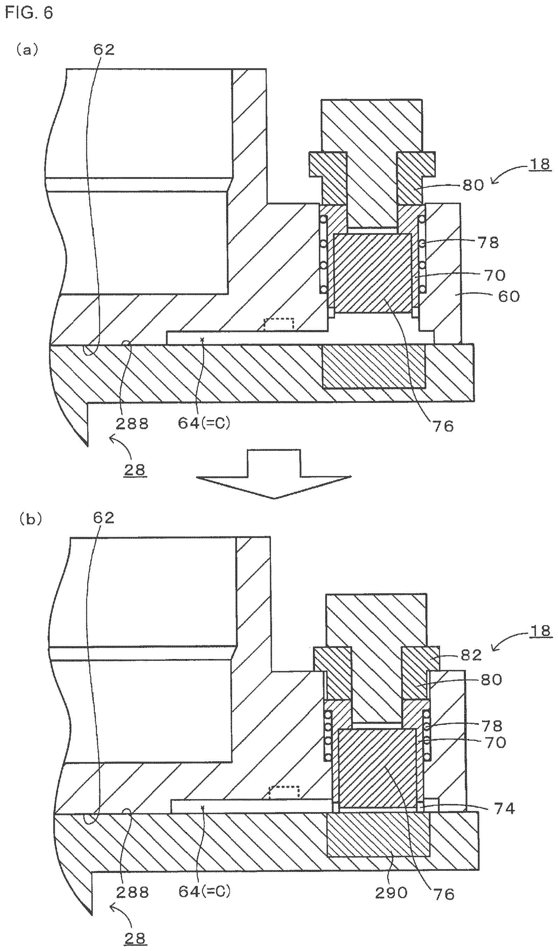

   Fig. 6 illustrates a procedure for attaching nozzle 28 to head 18.
Fig. 7

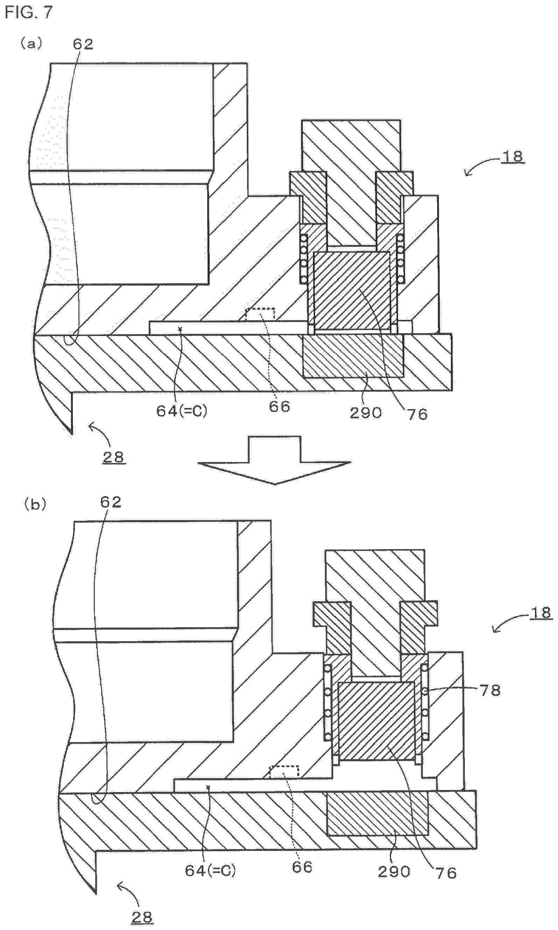

   Fig. 7 illustrates a procedure for removing nozzle 28 from head 18.

### Description of Embodiments

Hereinafter, an embodiment of the present invention will be described with reference to the figures. Fig. 1 is a perspective view of component mounting device 10; fig. 2 shows electrical connections of component mounting device 10; fig. 3 shows a cross section of a nozzle holding mechanism; fig. 4 shows nozzle-holding surface 62 from below; fig. 5 is a perspective view of magnet holder 70. In the present embodiment, left-right directions (X axis), front-rear directions (Y axis), and up-down directions (Z axis) are set as shown in fig. 1. Fig. 3 also includes an enlarged view of the portion enclosed by the dot-dash line.

As shown in fig. 1, component mounting device 10 is provided with board conveyance device 12, head 18, nozzle 28, mark camera 34, component camera 36, nozzle stocker 38, controller 40 (refer to fig. 2) that performs various types of control, and component supply section 50.

Board conveyance device 12 conveys board S from left to right using conveyor belts 16 and 16 (only one of these is shown in fig. 1) that are respectively attached to a pair of left and right conveyor rails 14 and 14. Also, board conveyance device 12 fixes board S by pushing board S from below via support pins 17 arranged below board S and contacting board S against guide sections of conveyor rails 14 and 14, and releases board S by lowering support pins 17.

Head 18 includes nozzle 28 on a lower surface. Head 18 is removably attached to a front surface of X-axis slider 20. X-axis slider 20 is slidably attached to a pair of lower and upper guide rails 22 and 22 that are attached to a front surface of Y-axis slider 24 and that extend in the left-right direction. Y-axis slider 24 is integrated with nut 23 engaged on Y-axis ball screw 25 and is slidably attached to a pair of left and right guide rails 26 and 26 that extend in the front-rear direction. One end of Y-axis ball screw 25 is attached to Y-axis motor 24a and the other end is free. Y-axis slider 24 is slid along guide rails 26 and 26 by this ball screw mechanism. In other words, when Y-axis motor 24a rotates, Y-axis ball screw 25 rotates, causing nut 23 to slide along guide rails 26 and 26 together with Y-axis slider 24. Although not shown, X-axis slider 20 is slid along guide rails 22 and 22 by a ball screw mechanism provided with X-axis motor 20a (refer to fig. 2) in a similar manner to Y-axis slider 24. Head 18 moves in a left-right direction in accordance with the left-right movement of X-axis slider 20 and moves in a front-rear direction in accordance with the front-rear movement of Y-axis slider 24.

Nozzle 28 uses pressure to pick up, hold, and release a component at a tip of the nozzle. The height of nozzle 28 is adjusted by Z-axis motor 30 built into head 18 and ball screw 32 extending along the Z axis.

Next, a nozzle holding mechanism whereby head 18 holds nozzle 28 is described with reference to figs. 3 to 5. Nozzle 28 is held in a removable manner to nozzle-holding surface 62, which is a lower surface of nozzle holding body 60 provided on the lower side of head 18. As shown in fig. 4, nozzle-holding surface 62 is circular when seen from below and is provided with ring-shaped groove 64 (recess). Pressure adjusting outlet 66 is provided on groove 64. Pressure adjusting device 68 is connected to pressure adjusting outlet 66. Pressure adjusting device 68 is connected to positive pressure source 68a that supplies pressure higher than atmospheric pressure (positive pressure), negative pressure source 68b that supplies pressure lower than atmospheric pressure (negative pressure), and an atmosphere opening, and is configured to supply positive pressure, negative pressure, or atmospheric pressure to groove 64 via an in-built switching valve 68c. Magnet 76 held by tubular magnet holder 70 is provided at two locations on groove 64 (along a diameter line of nozzle-holding surface 62). Magnet 76 is held by magnet holder 70 such that the height of the lower surface of magnet 76 is higher than the lower surface of magnet holder 70. As shown in fig. 5, multiple slit-type cutouts 74 (through-holes) are provided on the lower surface of magnet holder 70 in a circumferential direction. Magnet holder 70 holding magnet 76 is inserted into stepped hole 63 of nozzle holding body 60. Holder flange 72 is provided along the upper circumferential edge of magnet holder 70. Coil spring 78 is arranged between the stepped portion of stepped hole 63 and holder flange 72. Tubular stopper 80 is layered on an upper surface of magnet holder 70. Stopper flange 82 is provided along the upper circumferential edge of stopper 80 extending outwards. The diameter of stopper flange 82 is larger than the upper opening of stepped hole 63. Magnet holder 70 and stopper 80 are layered such their respective center axes are aligned, and are attached to each other by bolts 84. In other words, a through-hole screw hole is provided in a vertical direction in the center of magnet holder 70 on the upper side of magnet holder 70, a through-hole screw hole is provided in a vertical direction in the center of stopper 80, and the two are connected by bolt 84 being inserted into the screw holes. Thus, magnet holder 70 that holds magnet 76 and stopper 80 can move together vertically in stepped hole 63, with the movement downwards being restricted by stopper flange 82 contacting the upper edge of stepped hole 63.

Nozzle 28 is provided with nozzle main body 282 and disk-shaped nozzle flange 286. Nozzle main body 282 is provided with through-hole 284 that extends through a center axis of nozzle main body 282 in a vertical direction. Negative pressure, positive pressure, or atmospheric pressure is supplied from a nozzle pressure adjusting device, not shown, to through-hole 284. Nozzle flange 286 is integrated with an upper section of nozzle main body 282. Metal plate 290 (metal member) made from a material attracted to magnet 76 (for example, an iron group element such as iron, cobalt, or nickel) is embedded in a held surface that is an upper surface of nozzle flange 286 at a position opposite magnet 76.

A procedure for attaching nozzle 28 to nozzle-holding surface 62 of head 18 will be described with reference to fig. 6. Fig. 6 illustrates such a procedure. First, as shown in fig. 6(a), nozzle-holding surface 62 of head 18 is contacted against held surface 288 of nozzle 28. Here, the center of nozzle-holding surface 62 is aligned with the center of held surface 288 of nozzle 28. Thus, groove 64 of nozzle-holding surface 62 becomes pressure adjustment chamber C by being covered by held surface 288 of nozzle 28. At this stage, magnet holder 70 that holds magnet 76 and stopper 80 are positioned at a position (normal position) so as to be separated from nozzle-holding surface 62 from above by coil spring 78. Next, negative pressure is supplied to pressure adjustment chamber C via pressure adjusting device 68. When this happens, held surface 288 of nozzle 28 is sucked to nozzle-holding surface 62 of head 18 by the negative pressure. At the same time, because magnet 76 is elastically supported by coil spring 78 facing groove 64, as shown in fig. 6(b), due to the negative pressure, magnet 76 moves down against the biasing of coil spring 78, that is, towards held surface 288 of nozzle 28, with the lower surface of magnet holder 70 stopping at a position (attract position) where it contacts metal plate 290 of nozzle 28. Because the height of the lower surface of magnet 76 is higher than the lower surface of magnet holder 70, a specified gap is formed between magnet 76 and metal plate 290. The size of this gap depends on the difference in the heights of the lower surface of magnet holder 70 and the lower surface of magnet 76. The gap is set such that even if the negative pressure is interrupted nozzle 28 continues to be held on nozzle-holding surface 62 of head 18 due to the attraction of metal plate 290 and magnet 76 while metal plate 290 is facing magnet 76. The pressure of pressure adjustment chamber C reaches the lower surface of magnet 76 via cutouts 74 provided on the lower surface of magnet holder 70. Stopper 80 integrated with magnet holder 70 also decides the lower limit position of magnet 76, and normally, when the lower surface of magnet holder 70 is contacting metal plate 290, stopper flange 82 contacts the circumferential edge of the upper opening of stepped hole 63, but there are cases in which this may not occur due to tolerances or the like. Thus, the gap between magnet 76 and metal plate 290 actually depends on the difference in the heights of the lower surface of magnet holder 70 and the lower surface of magnet 76.

Returning to fig. 1, mark camera 34 is provided on a lower surface of head 18 with an imaging direction facing board S, and is able to move in XY directions together with head 18. Mark camera 34 is used to image board marks, not shown, provided on board S that are used for positioning the board S.

Component camera 36 is provided between component supply unit 50 and board conveyance unit 12 roughly in the middle in the left-right direction, and is arranged such that the imaging direction is upwards. Component camera 36 images a component held by nozzle 28 that passes over component camera 36.

Nozzle stocker 38 stocks multiple types of nozzles 28 in storage holes 38a. Nozzle stocker 38 is arranged next to component camera 36. Nozzles 28 are exchanged as appropriate for the type of component and type of board on which the component is to be mounted.

As shown in fig. 2, mounting controller 40 is configured as a microprocessor centered around CPU40a and is provided with ROM 40b for memorizing processing programs, HDD 40c for memorizing various types of data, and RAM 40 used as working memory. Connected to mounting controller 40 are input device 40e such as a mouse and keyboard, and display device 40f such as a liquid crystal display. Mounting controller 40 is connected to feeder controller 57 built into feeder 56 and management computer 90 such that two-way communication is possible. Also, mounting controller 40 is connected to board conveyance device 12, X-axis motor 20a, Y-axis motor 24a, Z-axis motor 30, mark camera 34, component camera 36, pressure adjusting device 68, and the like such that control signals can be outputted. Further, mounting controller 40 is connected to mark camera 34 and component camera 36 such that images can be received. For example, mounting controller 40 recognizes the position of board S by processing an image of board S captured by mark camera 34 and identifying the positions of board marks, which are not shown in the figures. Also, mounting controller 40 determines whether a component is being held by nozzle 28, and the size, shape, holding position, and the like of the component based on an image captured by component camera 36.

As shown in fig. 1, component supply section 50 is provided with feeder pallet 52 and feeders 56. Multiple slots 54 are provided on an upper surface of feeder pallet 52. Slot 54 is a groove into which a feeder 56 can be inserted. Feeder 56 holds reel 58 around which tape is wound such that reel 58 can be rotated. Multiple recesses, not shown, are formed in the tape in a lengthwise direction of the tape. A component is stored in each recess. These components are protected by a film, not shown, that covers the upper surface of the tape. The component pickup position at feeder 56 is predetermined. The component pickup position is determined as the position at which nozzle 28 picks up the component based on design values. By the tape being fed to the rear by a specified amount each time by feeder 56, components stored in the tape are consecutively arranged at the component supply position. The film is peeled off such that when a component reaches the component pickup position the component can be picked up by nozzle 28.

As shown in fig. 2, management computer 90 is provided with computer main body 92, input device 94, and display 96, such that an operator can enter commands from input device 94 and various images can be output on display 96. Production job data is memorized on memory of computer main body 92. The following are defined in the production job data for production to be performed using component mounting device 10: which components are to be mounted to board S and in what order, how many of those boards S are to be manufactured, and so on.

Operations (component mounting operations) whereby mounting controller 40 of component mounting device 10 mounts components on board S based on the production job are described next. First, mounting controller 40 uses nozzle 28 of head 18 to pick up a component supplied from a feeder 56 of component supply section 50. Specifically, mounting controller 40 controls X-axis motor 20a of X-axis slider 20 and Y-axis motor 24a of Y-axis slider 24 such that nozzle 28 of head 18 is moved directly above the component pickup position of the desired component. Then, mounting controller 40 controls Z-axis motor 30 such that nozzle 28 is lowered and negative pressure supplied to through-hole 284 of nozzle 28. In this way, the desired component is picked up by the tip portion of nozzle 28. Next, mounting controller 40 raises nozzle 28 and controls X-axis slider 20 and Y-axis slider 24 to move nozzle 28 holding the component to a specified position above board S. Then, at the specified position, mounting controller 40 performs control to lower nozzle 28 and supply atmospheric pressure to through-hole 284. Thus, the component held by nozzle 28 is released and mounted at the specified position on board S. Other components are mounted onto board S in a similar manner and when mounting of all components is complete the board S is sent downstream.

Described next are operations performed by mounting controller 40 of component mounting device 10 to automatically exchange nozzle 28 of head 18. When it is necessary to exchange a nozzle, mounting controller 40 controls X-axis motor 20 and Y-axis motor 24a such that nozzle 28 held by head 18 is moved above a specified storage hole 38a of nozzle stocker 38. Then, mounting controller 40 controls Z-axis motor 30 such that the nozzle 28 held by head 18 is stored in the specified storage hole 38a of nozzle stocker 38.

Fig. 7 illustrates a procedure for removing nozzle 28 from head 18. Nozzle 28 held by head 18 is shown in fig. 7(a) in a state inserted into storage hole 38a. That is, nozzle 28 is held by being sucked to nozzle-holding surface 62 of head 18 by negative pressure inside pressure adjustment chamber C, and is held by metal plate 290 being attracted by the magnetic force of magnet 76 that is at the attract position. Continuing, mounting controller 40 supplies positive pressure from pressure adjusting device 68 via pressure adjustment outlet 66 to pressure adjustment chamber C that until that point was being supplied with negative pressure. When this is done, nozzle 28 is no longer sucked to head 18 by negative pressure. Further, as shown in fig. 7(b), because magnet 76 is moved from the attract position to a position (normal position) separated from nozzle-holding surface 62 due to the biasing of coil spring 78 and the positive pressure inside pressure adjustment chamber C, the attraction of metal plate 290 provided in nozzle 28 is also canceled. That is, nozzle 28 is no longer attached to head 18 by magnetic force. Thus, nozzle 28 can be removed quickly during nozzle exchange by supplying positive pressure to pressure adjustment chamber C.

Mounting controller 40, in a state with atmospheric pressure supplied to pressure adjustment chamber C, performs control to move head 18 from which the nozzle 28 was removed to a position above the storage hole 38a storing the next nozzle 28 to be used and then contact nozzle-holding surface 62 of head 18 against held surface a288 of the next nozzle 28 to be used. In that state, mounting controller 40 performs control to supply negative pressure to pressure adjustment chamber C from pressure adjusting outlet 66 via pressure adjusting device 68. When this happens, held surface 288 of nozzle 28 is sucked to nozzle-holding surface 62 by the negative pressure. Also, magnet 76 attached to head 18 is moved by the negative pressure against the biasing force of coil spring 78 from the normal position to the attach position. As a result, nozzle 28 is held by being sucked to head 18 by negative pressure, and is held by being attracted to head 18 by magnetic force. In this manner, automatic exchange of nozzles 28 is performed.

With the above-described component mounting device 10, when negative pressure is supplied to pressure adjustment chamber C formed from groove 64 that is connected to nozzle-holding surface 62 of head 18 and held surface 288 of nozzle 28, due to the negative pressure held surface 288 of nozzle 28 is sucked to nozzle-holding surface 62. Also, magnet 76 attached to head 18 is moved by the negative pressure against the biasing force of coil spring 78 from the normal position to the attach position. That is, nozzle 28 is held by being sucked to head 18 by negative pressure, and is held by being attracted to head 18 by magnetic force. Therefore, even if the negative pressure is interrupted by an event such as a power cut, nozzle 28 is held to head 18 by the magnetic force and does not drop from head 18. On the other hand, to remove nozzle 28, positive pressure is supplied to pressure adjustment chamber C. When this is done, nozzle 28 is no longer sucked to head 18 by negative pressure. Also, because magnet 76 is moved to the normal position by the positive pressure and the biasing of coil spring 78, the attraction to metal plate 290 provided on nozzle 28 is canceled. That is, nozzle 28 is no longer attached to head 18 by magnetic force. Thus, nozzle 28 can be removed quickly during nozzle exchange by supplying positive pressure to pressure adjustment chamber C.

Further, because metal plate 290 is held by a magnetic force in a state with a gap maintained between the magnet 76 and metal plate 290 when magnet 76 is at the attract position, there is no direct contact with metal plate 290, meaning that damage such as cracking is unlikely. This means magnet 76 can be used for a long time. Also, when positive pressure is supplied to pressure adjustment chamber C, because the positive pressure causes magnet 76 to be raised thereby increasing the gap between magnet 76 and metal plate 290, it is easy for magnet 76 to return to the normal position from the attract position.

Further, when magnet 76 is at the attract position, because the gap between magnet 76 and metal plate 290 is maintained by the lower surface of magnet holder 70 contacting metal plate 290, it is easy to manage the size of the gap. Also, when positive pressure is supplied to pressure adjustment chamber C, because the positive pressure of pressure adjustment chamber C reaches the lower surface of magnet 76 via cutouts 74 of magnet holder 70, it is easy to push up the magnet positioned at the attract position.

Further, because it is not necessary to open and close a shutter of nozzle stocker 38 when performing nozzle exchange, automatic exchange of nozzles can be performed swiftly. Costs are also reduced by eliminating the shutter mechanism.

Meanwhile, it goes without saying that the invention is not limited to the above-mentioned embodiment and various embodiments may be applied within the technical scope of the invention defined in the appended claims.

Further, magnet holder 70 and stopper 80 are joined together by bolt 84, but stopper 80 and bolt 84 may be omitted. In this case, too, because a gap is maintained between magnet 76 and metal plate 290 without the lower surface of magnet holder 70 contacting metal plate 290, the same effects as the embodiments above are realized.

Still further, with magnet 76 at the attract position, a gap is maintained between magnet 76 and metal plate 288, but if a magnet 76 with excellent shock resistance is used, magnet 76 may contact metal plate 288. Specifically, the lower surface of magnet 76 and the lower surface of magnet holder 70 may be at the same height. In this case, the design may be such that if positive pressure is supplied to pressure adjustment chamber C with magnet 76 at the attract position, magnet 76 returns to the normal position by positive pressure being supplied to cutouts 74 of magnet holder 70.

Still further, one nozzle 28 is attached to head 18, but a nozzle holding mechanism with multiple nozzles may be attached to head 18.

Also, there are two pairs of magnets 76 and metal plates 290, but there may be three or more pairs of those items.

### Industrial Applicability

The present application can be applied to a component mounting device.

### Reference Signs List

10: component mounting device; 12: board conveyance device; 14: conveyor rail; 16: conveyor belt; 17: support pin; 18: head; 20: X-axis slider; 20a: X-axis motor; 22: guide rail; 23: nut; 24: Y-axis slider; 24a: Y-axis motor; 25: Y-axis ball screw; 26: guide rail; 28: nozzle; 30: Z-axis motor; 32: ball screw; 34: mark camera; 36: component camera; 38: nozzle stocker; 38a: storage hole; 40: mounting controller; 40a: CPU; 40b: ROM; 40c: HDD; 40d: RAM; 40e: input device; 40f: display device; 50: component supply section; 52: feeder pallet; 54: slot; 56: feeder; 57: feeder controller; 58: reel; 60: nozzle holding body; 62: nozzle-holding surface;63: stepped hole; 64: groove; 66: pressure adjusting outlet; 68: pressure adjusting device; 68a: positive pressure source; 68b: negative pressure source; 68c: switching valve; 70: magnet holder; 72: holder flange; 74: cutout; 76: magnet; 78: coil spring; 80: stopper; 82: stopper flange; 84: bolt; 90: management computer; 92: computer main body; 94: input device; 96: display; 282: nozzle main body; 284: through-hole; 286: nozzle flange; 288: held surface; 290: metal plate

## Claims

1. A nozzle holding mechanism configured to hold a held surface (288) of a nozzle (28) to a nozzle-holding surface (62) of a head (18) using negative pressure, the nozzle holding mechanism comprising:
a recess (64) provided on one of the nozzle-holding surface (62) or the held surface (288); a pressure adjusting means (68) connected to the recess (64); **characterized by** a magnet (76) attached to the head (18) so as to face the recess (64) and to have a changeable positional relationship with the nozzle-holding surface (62), the magnet (76) being arranged such that at a normal position the magnet (76) is separated from the nozzle-holding surface (62) by an elastic body (78) in a state in which the nozzle (28) is not being held by the nozzle-holding surface (62), the magnet (78) being configured to provide a magnetic force to hold the nozzle (28) to the head (18) only by means of the magnetic force; and
a metal member (290) attached to the held surface (288) of the nozzle (28) at a position opposite the magnet (76) on the held surface (288) of the nozzle (28) and made from a material attracted to the magnet (76);
wherein
when negative pressure is supplied via the pressure adjusting means (68) to a pressure adjustment chamber (C) formed from the recess (64) that is connected to the nozzle-holding surface (62) and the held surface (288), due to the negative pressure the held surface (288) is configured to be sucked to the nozzle-holding surface (62), and the magnet (76) is configured to be moved against biasing of the elastic body (78) from the normal position to an attract position at which the metal member (290) is configured to be attracted to the magnet (76) by magnetic force, and, when positive pressure is supplied to the pressure adjustment chamber (C) via the pressure adjusting means (68), due to the biasing by the elastic body (78) and the positive pressure the magnet (76) is configured to be moved to the normal position such that the attraction of the metal member (290) to the held surface (288) is released.

2. The nozzle holding mechanism according to claim 1, wherein
the magnet (76), when at the attract position, is configured to attract the metal member (290) in a state opposite to and separated by a gap from the metal member (290).

3. The nozzle holding mechanism according to claim 2, further comprising:
a tubular magnet holder (70) configured to hold the magnet (76),
wherein
the magnet (76) is configured to held by the magnet holder (70) such that a height of a lower surface of the magnet (76) is higher than a lower surface of the magnet holder (70), and air of the pressure adjustment chamber (C) is configured to reach the lower surface of the magnet (76) via an outlet of the magnet holder (70), such that, when the magnet (76) is at the attract position, the lower surface of the magnet holder (70) is configured to contact the metal member (290) and the lower surface of the magnet (76) is configured to attract the metal member (290) in a state in which the lower surface of the magnet (76) is separated by a gap from the metal member (290).

4. A component mounting device (10) provided with the nozzle holding mechanism according to any one of the claims 1 to 3.

## Patentansprüche

1. Düsen-Haltemechanismus, der so ausgeführt ist, dass er eine gehaltene Fläche (288) einer Düse (28) mittels Unterdruck an einer Düsen-Haltefläche (62) eines Kopfes (18) hält, wobei der Düsen-Haltemechanismus umfasst:
eine Aussparung (64), die an der Düsen-Haltefläche (62) oder an der gehaltenen Fläche (288) vorhanden ist;
eine Druck-Einstelleinrichtung (68), die mit der Aussparung (64) verbunden ist,
**gekennzeichnet durch**
einen Magneten (76), der an dem Kopf (18) so angebracht ist, dass er der Aussparung (64) zugewandt ist und eine veränderbare Positionsbeziehung zu der Düsen-Haltefläche (62) hat, wobei der Magnet (76) so angeordnet ist, dass in einer normalen Position der Magnet (76) von der Düsen-Haltefläche (62) durch einen elastischen Körper (78) in einem Zustand getrennt ist, in dem die Düse (28) nicht von der Düsen-Haltefläche (62) gehalten wird, und der Magnet (78) so ausgeführt ist, dass er eine Magnetkraft bereitstellt, um die Düse (28) nur mittels der Magnetkraft an dem Kopf (18) zu halten; sowie
ein Metallelement (290), das an der gehaltenen Fläche (288) der Düse (28) an einer dem Magneten (76) an der gehaltenen Fläche (288) der Düse (28) gegenüberliegenden Position angebracht ist und aus einem Material besteht, das von dem Magneten (76) angezogen wird;
wobei
die gehaltene Fläche (288) so ausgeführt ist, dass sie, wenn Unterdruck über die Druck-Einstelleinrichtung (68) einer Druck-Einstellkammer (C) zugeführt wird, die aus der Aussparung (64) besteht, die mit der Düsen-Haltefläche (62) und der gehaltenen Fläche (288) verbunden ist, aufgrund des Unterdrucks an die Düsen-Haltefläche (62) angesaugt wird, und der Magnet (76) so ausgeführt ist, dass er gegen Vorspannung des elastischen Körpers (78) von der Ruhe-Position an eine Anzieh-Position bewegt wird, und das Metallelement (290) so ausgeführt ist, dass es in dieser Position durch Magnetkraft von dem Magneten (76) angezogen wird, und der Magnet (76) so ausgeführt ist, dass er, wenn der Druck-Einstellkammer (C) über die Druck-Einstelleinrichtung (68) Überdruck zugeführt wird, aufgrund der Vorspannung durch den elastischen Körper (78) und des Überdrucks an die Ruhe-Position bewegt wird, so dass die Anziehung des Metallelementes (290) an die gehaltene Fläche (288) aufgehoben wird.

2. Düsen-Haltemechanismus nach Anspruch 1, wobei
der Magnet (76) so ausgeführt ist, dass er, wenn er sich in der Anzieh-Position befindet, das Metallelement (290) in einem Zustand anzieht, in dem er dem Metallelement (290) gegenüberliegt und durch einen Spalt von ihm getrennt ist.

3. Düsen Haltemechanismus nach Anspruch 2, der des Weiteren umfasst:
einen röhrenförmigen Magnet-Halter (70), der zum Halten des Magneten (76) ausgeführt ist,
wobei
der Magnet (76) so ausgeführt ist, dass er von dem Magnet-Halter (70) so gehalten wird, dass eine Höhe einer Unterseite des Magneten (76) höher ist als eine Unterseite des Magnet-Halters (70), und Luft der Druck-Einstellkammer (C) so ausgeführt ist, dass sie über einen Auslass des Magnet-Halters (70) an die Unterseite des Magneten (76) gelangt, so dass die Unterseite des Magnethalters (70) so ausgeführt ist, dass sie, wenn sich der Magnet (76) in der Anzieh-Position befindet, mit dem Metallelement (290) in Kontakt ist, und die Unterseite des Magneten (76) so ausgeführt ist, dass sie das Metallelement (290) in einem Zustand anzieht, in dem die Unterseite des Magneten (76) durch einen Spalt von dem Metallelement (290) getrennt ist.

4. Vorrichtung zum Montieren von Bauteilen (10), die mit dem Düsen-Haltemechanismus nach einem der Ansprüche 1 bis 3 versehen ist.

## Revendications

1. Mécanisme de maintien de buse configuré pour maintenir une surface maintenue (288) d'une buse (28) sur une surface de maintien de buse (62) d'une tête (18) en utilisant une pression négative, le mécanisme de maintien de buse comprenant :
un évidement (64) prévu sur l'une de la surface de maintien de buse (62) ou de la surface maintenue (288) ;
des moyens d'ajustement de pression (68) reliés à l'évidement (64) ; **caractérisé par** un aimant (76) fixé à la tête (18) de manière à faire face à l'évidement (64) et à avoir une relation de position modifiable avec la surface de maintien de buse (62), l'aimant (76) étant agencé de telle sorte qu'à une position normale, l'aimant (76) est séparé de la surface de maintien de buse (62) par un corps élastique (78) dans un état dans lequel la buse (28) n'est pas maintenue par la surface de maintien de buse (62), l'aimant (78) étant configuré pour fournir une force magnétique pour maintenir la buse (28) sur la tête (18) uniquement au moyen de la force magnétique ; et
un élément métallique (290) fixé à la surface maintenue (288) de la buse (28) à une position opposée à l'aimant (76) sur la surface maintenue (288) de la buse (28) et constitué d'un matériau attiré vers l'aimant (76) ;
dans lequel
lorsqu'une pression négative est fournie via les moyens d'ajustement de pression (68) à une chambre d'ajustement de pression (C) formée à partir de l'évidement (64) qui est relié à la surface de maintien de buse (62) et à la surface maintenue (288), en raison de la pression négative, la surface maintenue (288) est configurée pour être aspirée vers la surface de maintien de buse (62), et l'aimant (76) est configuré pour être déplacé à l'encontre d'une sollicitation du corps élastique (78) depuis la position normale vers une position d'attraction à laquelle l'élément métallique (290) est configuré pour être attiré vers l'aimant (76) par une force magnétique, et, lorsqu'une pression positive est fournie à la chambre d'ajustement de pression (C) via les moyens d'ajustement de pression (68), en raison de la sollicitation par le corps élastique (78) et de la pression positive, l'aimant (76) est configuré pour être déplacé vers la position normale de telle sorte que l'attraction de l'élément métallique (290) vers la surface maintenue (288) est relâchée.

2. Mécanisme de maintien de buse selon la revendication 1, dans lequel l'aimant (76), lorsqu'il se trouve dans la position d'attraction, est configuré pour attirer l'élément métallique (290) dans un état en vis-à-vis de l'élément métallique (290), et séparé de celui-ci par un espace.

3. Mécanisme de maintien de buse selon la revendication 2, comprenant en outre :
un dispositif de maintien d'aimant tubulaire (70) configuré pour maintenir l'aimant (76), dans lequel
l'aimant (76) est configuré pour être maintenu par le dispositif de maintien d'aimant (70) de telle sorte qu'une hauteur d'une surface inférieure de l'aimant (76) est plus élevée qu'une surface inférieure du dispositif de maintien d'aimant (70), et de l'air de la chambre d'ajustement pression (C) est configuré pour atteindre la surface inférieure de l'aimant (76) via une sortie du dispositif de maintien d'aimant (70), de sorte que, lorsque l'aimant (76) est dans la position d'attraction, la surface inférieure du dispositif de maintien d'aimant (70) est configurée pour entrer en contact avec l'élément métallique (290) et la surface inférieure de l'aimant (76) est configurée pour attirer l'élément métallique (290) dans un état dans lequel la surface inférieure de l'aimant (76) est séparée de l'élément métallique (290) par un espace.

4. Dispositif de montage de composants (10) muni du mécanisme de maintien de buse selon l'une quelconque des revendications 1 à 3.
